# EUROPÄISCHE PATENTSCHRIFT

(11) **EP 4 166 967 B1**
(45) Veröffentlichungstag und Bekanntmachung des Hinweises auf die Patenterteilung: **22.05.2024**
(21) Anmeldenummer: 22206260.6
(22) Anmeldetag: 19.11.2019
(51) Int. Cl.: G01R 31/58, G01R 31/08, H02G 11/00

(54) **SYSTEM ZUR LEITUNGSÜBERWACHUNG IN EINER LEITUNGSFÜHRUNGSEINRICHTUNG, INSBESONDERE IN EINER ENERGIEFÜHRUNGSKETTE**
SYSTEM FOR MONITORING LINES IN A LINE GUIDING DEVICE, IN PARTICULAR IN AN ENERGY GUIDING CHAIN
SYSTÈME DE SURVEILLANCE DE LIGNES DANS UN DISPOSITIF DE GUIDAGE DE LIGNES, EN PARTICULIER DANS UNE CHAÎNE PORTE-CÂBLES

(30) Priorität: 19.11.2018 DE 202018106543 U
(43) Veröffentlichungstag der Anmeldung: 19.04.2023
(62) Teilanmeldung aus: 19808741.3
(73) Patentinhaber: igus GmbH, 51147 Köln (DE)
(72) Erfinder: Habering, Richard, 51143 Köln (DE); Krista, Sebastian, 53773 Hennef (DE)
(74) Vertreter: Lippert Stachow Patentanwälte Rechtsanwälte

(56) Entgegenhaltungen:
- WO-A1-2015/145068
- WO-A1-2018/115528
- WO-A1-2018/196949
- US-A1- 2013 154 676

## Beschreibung

Die Erfindung betrifft allgemein ein System zur Überwachung der Betriebsbereitschaft bzw. des Verschleißzustands einer Leitung, die innerhalb einer bzw. durch eine aktive Leitungsführungseinrichtung geführt ist. Solche Leitungsführungseinrichtungen, dienen zum dynamischen Führen mindestens einer Leitung, wie z.B. eines Kabels, Schlauchs oder dergleichen, meist zwischen einer feststehenden Anschlussstelle bzw. Basis und einer dazu relativbeweglichen weiteren Anschlussstelle, z.B. einem Mitnehmer.

Die Erfindung betrifft insbesondere ein System zur Überwachung einer Datenleitung, welche z.B. einen beweglichen Teil einer Maschine oder Anlage mit Daten versorgt bzw. davon ausgehende Daten überträgt, und welche durch die Leitungsführungseinrichtung geschützt bzw. geführt ist.

Gattungsgemäße Leitungsführungseinrichtung schützen typisch Leitungen, welche bewegte Maschinen- oder Anlagenkomponenten mit Energie, Daten und/oder Betriebsmedien versorgen. Eine gattungsgemäße Leitungsführungseinrichtung ist z.B. eine verfahrbare Energieführungskette an sich bekannter Bauart.

Im Betrieb bildet eine in einer Ebene verfahrbare Energieführungskette typisch ein bewegliches Trum mit einem Anschlussende, ein ruhendes Trum mit einem Anschlussende sowie zwischen beiden Trumen einen Umlenkbogen. In einer Ebene, z.B. horizontal oder vertikal, fahrbare Energieführungsketten hat die Anmelderin z.B. in EP 0 803 032 B1 oder WO 02/086349 A1 vorschlagen. Weiterhin bekannt sind dreidimensional auslenkbare Energieführungsketten, welche insbesondere bei Industrierobotern Anwendung finden. Eine räumlich auslenkbare Energieführungskette hat die Anmelderin z.B. in WO 2004/093279 A1 vorgeschlagen.

Ungeachtet der Bauart der Leitungsführungseinrichtung bzw. Energieführungskette, werden die geführten Leitungen im Betrieb dynamisch beansprucht. Die Leitungen unterliegen unvermeidbarem Verschleiß und werden daher mit steigender Anzahl gefahrener Bewegungszyklen ausfallgefährdet.

Neben der Leitungsführungseinrichtung umfasst das System eine Überwachungsvorrichtung mit mindestens einer Überwachungsvorrichtung, die eine Auswerteeinheit aufweist, welche Information zum Zustand, insbesondere Verschleißzustand, der zu überwachenden Leitung ermittelt.

Ein gattungsgemäßes System nach dem Oberbegriff aus Anspruch 1 ist aus WO 2018/196949 A1 bekannt. Dieses System erlaubt die Leitungsüberwachung im laufenden Betrieb zwecks frühzeitiger Erkennung eines bevorstehenden Leitungsversagens, insbesondere zwecks prädiktiver Wartung (Engl. predictive maintenance) bzw. zur Vermeidung eines ungewollten Ausfalls der versorgten Maschine bzw. Anlage. Das System aus WO 2018/196949 A1 erfordert dazu einen speziellen Indikatorleiter und eine Schaltung mit einer Messeinrichtung zur Widerstands- oder Leitwertmessung.

Insbesondere beweglich geführte Datenleitungen sind im Vergleich zu Leitungen zur Stromversorgung typisch u.a. aufgrund höherer Anforderungen an die Leitungsqualität verschleißanfälliger bzw. weniger langlebig.

Eine Aufgabe der vorliegenden Erfindung ist es, eine alternative Lösung vorzuschlagen die gegenüber der vorbekannten Lösung insbesondere preiswerter realisierbar sein soll. Diese Aufgabe wird gelöst durch ein System nach Anspruch 1. Vorteilhafte bzw. bevorzugte Ausführungsformen ergeben sich aus den Unteransprüchen. Eine weitere Aufgabe besteht darin, ein besonders für verschleißanfälligere Datenleitungen geeignetes Überwachungssystem vorzuschlagen.

In einfachster und allgemeinster Form wird die Aufgabe dadurch gelöst, dass die Überwachungsvorrichtung ein erstes Gerät mit Schnittstelle zur Datenkommunikation und ein zweites Gerät mit Schnittstelle zur Datenkommunikation umfasst, wobei die Geräte bzw. Schnittstellen zur Datenkommunikation gemäß einem Protokoll zur digitalen Datenübertragung eingerichtet sind. Dabei sind die Schnittstellen beider Geräte über eine Leitung verbunden, die zumindest über einen Teil ihrer Länge durch die bzw. in der Leitungsführungseinrichtung geführt ist. Die Auswerteeinheit ist erfindungsgemäß so eingerichtet bzw. konfiguriert, dass sie eine Information zum Zustand, insbesondere Verschleißzustand, der zu überwachenden Leitung auf Grundlage eines informatischen Qualitätsmerkmals der Datenverbindung zwischen dem ersten Gerät und dem zweiten Gerät gewinnt bzw. ermittelt. Ein informatisches Qualitätsmerkmal bezeichnet dabei insbesondere ein von der Qualität der Datenverbindung abhängiges Merkmal, das sich mit einer Technik aus der Informationstechnologie, insbesondere auch einer an sich bereits bekannten IT-Technik bestimmen lässt. Das Qualitätsmerkmal kann z.B. einer ausgewählten Übertragungseigenschaft entsprechen bzw. ein Indikator hierfür sein.

Zwei wesentliche Vorteile dieser Lösung bestehen darin, dass einerseits an sich bekannte Technologie zur Datenkommunikation, wie beispielsweise Netzwerk-Technologie oder Bus-Technologie, eingesetzt werden kann und andererseits unter Ausnutzung eines durch geeignete Programmierung softwaremäßig bestimmbaren Qualitätsmerkmals der Datenverbindung ein Rückschluss auf die bestimmungsgemäße Betriebsbereitschaft bzw. den Verschleißzustand der zu überwachenden Leitung getroffen werden kann. Bei der zu überwachenden Leitung kann es sich insbesondere um die Leitungen zur Datenverbindung zwischen den Schnittstellen des ersten und zweiten Geräts handeln, dies ist jedoch nicht zwingend. Letztgenannte Leitung kann auch als Indikator für eine als kritisch betrachtete, andere zu überwachenden Leitung genutzt werden. Ein weiterer Vorteil liegt darin, dass keine speziellen Indikatorleiter eigens zur Überwachung benötigt werden (soz. keine "Opferadern"), sondern eine bereits vorgesehene bzw. vorhandene Leitung für digitale Kommunikation ausgenutzt werden kann. Die vorgeschlagene Lösung erfordert in der Regel auch keine Änderung bzw. besondere Anpassung der überwachten Leitung.

Ein informatisch bzw. datentechnisch bestimmbares Qualitätsmerkmal der Datenverbindung erlaubt dabei einen Rückschluss auf den Zustand der Datenleitung. Eine Verschlechterung (Engl. degradation) einer zuvor höheren Verbindungsqualität ist ein starkes Indiz für einen durch die dynamische Beanspruchung, etwa die Bewegungszyklen der Energieführungskette, oder auch durch sonstiges eventuelles Fehlverhalten, z.B. einen Kettenbruch, hervorgerufenen Verschleiß (Engl. wear) oder für eine Unterbrechung der Datenleitung. Daraus kann direkt oder indirekt ein Rückschluss auf den Zustand der überwachten Leitung gezogen werden, wobei letztere nicht zwingend mit der Datenleitung übereinstimmen muss. Das Qualitätsmerkmal der Datenverbindung kann dabei durch an sich bekannte Software-Funktionen bestimmt bzw. ermittelt werden. Somit ist die Lösung einfach und preiswert umsetzbar.

Ein informatisches Qualitätsmerkmal der Datenverbindung ist im vorliegenden Sinne insbesondere eine informatisch erfassbare Abstufung der mehr oder weniger ausgeprägten Güte der Datenverbindung zwischen dem ersten Gerät und dem zweiten Gerät, welche physisch durch eine zumindest anteilig in der Leitungsführungseinrichtung geführte Leitung realisiert ist.

Die Auswerteeinheit kann ein integraler Bestandteil des ersten Geräts sein oder als separates Modul ausgeführt sein. Die Auswerteeinheit kann in Form von anwendungsspezifischer Hardware oder als reines Softwaremodul auf einem Rechner vorgesehen werden.

Das vorgeschlagene System eignet sich grundsätzlich zur Überwachung von elektrischen oder auch optischen Leitungen, insbesondere von zumindest auch zur Datenübertragung geeigneten Leitungen. Die Erfindung erlaubt die Überwachung, insbesondere die unmittelbare Überwachung der Betriebsbereitschaft, von Datenleitungen und/oder Busleitungen, auch z.B. von Leitungen für Steuerungszwecke, wie Motor- oder und Servo-Leitungen, die Daten digital übertragen.

Als Protokoll kommt vorzugsweise ein Protokoll zur paketbasierten digitalen Datenübertragung in Betracht. In einer Ausführungsform ist vorgesehen, dass das Kommunikationsprotokoll zu Datenübertragung ein Datennetz-Protokoll, vorzugsweise ein Protokoll gemäß IEEE 802.3 ist. Dabei können an sich bekannte Technologien wie beispielsweise ETHERNET, PROFIBUS oder dergleichen zum Einsatz kommen. Es kommen insbesondere Geräte bzw. Schnittstellen in Betracht, die zur Datenkommunikation mit Paketvermittlung eingerichtet sind. Leitungsvermittlung wäre ebenfalls denkbar, ist jedoch nicht bevorzugt.

In einer alternativen Ausführungsform ist vorgesehen, dass das Protokoll zur Datenübertragung ein Datenbus-Protokoll, insbesondere ein industrielles Feldbus-Protokoll, ist. Hierbei kommen an sich bekannte Typen, wie etwa der CAN-, EIA-485 oder dergleichen in Betracht.

Die Bestimmung bzw. Ermittlung des informatischen Qualitätsmerkmals der Datenverbindung erfolgt vorzugsweise unter Ausnutzung an sich bekannter Techniken zur Adressierung der Geräte bzw. Schnittstellen. Vorzugsweise hat dabei jede Schnittstelle zur Datenkommunikation eine eindeutige Adresse, die jedenfalls im Datennetz bzw. im Datenbus eindeutig vorgegeben ist, wie beispielsweise eine MAC-Adresse.

Insbesondere bei adressbasierter Bestimmung des Qualitätsmerkmals wird das Qualitätsmerkmal vorzugsweise informatisch unter Ausnutzung von Datenübertragung, die an das zweite Gerät adressiert ist, ermittelt.

In bevorzugter Weiterbildung ist die Auswerteeinheit eingerichtet, um das Qualitätsmerkmal laufend zu bestimmen. Die Auswerteeinheit kann dabei z.B. das aktuell bestimmte Qualitätsmerkmal mit einem vorbestimmten oder alterungsabhängig angepassten Referenzwert vergleichen, um hinsichtlich der Betriebsbereitschaft der zu überwachenden Leitung einen Gut-Fall bzw. einen Schlecht-Fall zu erkennen bzw. zu diskriminieren. Die Auswerteeinheit kann z.B. eingerichtet sein, um das Qualitätsmerkmal in regelmäßigen Zeitabständen zu ermitteln.

Die Auswerteeinheit kann aufgrund der erfindungsgemäßen Lösung so eingerichtet sein, dass sie das Qualitätsmerkmal rein informatisch bzw. softwaremäßig bestimmt, insbesondere ohne die Notwendigkeit zur analogen Messung elektrischer Größen an der Leitung.

Besonders bevorzugt erfolgt die softwaremäßige Bestimmung des Qualitätsmerkmals unter Ausnutzung von protokollinhärent vorhandenen Funktionen zur Bewertung der Verbindungsgüte. Diese Funktionen können in einer beliebigen Schicht des OSI-Modells bereitgestellt sein.

Die Bestimmung bzw. Bewertung des Qualitätsmerkmals kann durch unterschiedliche Software-Maßnahmen erfolgen, beispielsweise anhand von:
- Erreichbarkeitsanfragen vom ersten Gerät an das zweite Gerät;
- Empfangsbestätigungen vom zweiten Gerät an das erste Gerät; und/oder
- Paketverlusten bzw. Paketverlustraten bei paketbasierter Datenübertragung; und/oder
- mindestens einer protokollinhärenten Funktion zur Beurteilung eines Dienstgüte(QoS)-Parameters, wie z.B. Paketverlustraten, Paket-Rundlaufzeiten (RTT), Latenzzeiten usw.

Erreichbarkeitsanfragen, Empfangsbestätigungen oder die Ermittlung von Paketverlusten können dabei als Funktion des verwendeten Datenprotokolls protokollinhärent bereits vorgesehen sein, oder eigens zu diesem Zweck programmiert werden.

Auch andere Qualitätsmerkmale kommen je nach Anwendungsfall in Betracht. Als ein bevorzugter Ansatz wird derzeit die laufende Überwachung der Paketverlustrate und deren Vergleich mit einem Schwellwert bzw. einprogrammierten oder angelernten Referenzwert angesehen. Es können auch mehrere unterschiedliche Qualitätsmerkmale überwacht und ausgewertet werden, z.B. zwecks Gewichtung bei der Entscheidung über einen erforderlichen Austausch der Leitung oder zwecks Gegenprüfung der überwachten Parameter untereinander.

In einer Ausführungsform kann beispielsweise vorgesehen sein, dass das erste Gerät Erreichbarkeitsanfragen, beispielsweise vom Typ ECHO-Anfrage bzw. PING-Nachricht, gemäß einem im OSI-Modell übergeordneten Protokoll an das zweite Gerät sendet. Geeignet sind beispielsweise ein ICMP-ECHO-Request gemäß IP-Protokoll oder ein UDP-Echo-Request oder dergleichen. Davon ausgehend kann die Auswerteeinheit die Qualität der Datenverbindung beispielsweise anhand des Ausbleibens entsprechender Antworten des zweiten Geräts, wie beispielsweise ECHO-Antworten, PONG-Nachrichten oder dergleichen, beurteilen. Die Beurteilung kann ebenfalls anhand der Veränderung der Antworten gegenüber einer Referenzantwort erfolgen.

In einer Ausführungsform kann das erste Gerät die Auswerteeinheit umfassen bzw. darstellen. Die Auswerteeinheit weist vorzugsweise eine programmierbare, integrierte Schaltung, wie beispielsweise einen Mikrocontroller oder dergleichen, auf, welche durch Programmierung softwaremäßig zur Verwirklichung einer der vorstehenden Ausführungsformen eingerichtet ist.

Zur Ausnutzung bestehender Technologien kann vorgesehen sein, dass am basisseitigen Anschlussende der Leitungsführungseinrichtung ein aktives Netzgerät, wie beispielsweise ein ETHERNET-Switch, ETHERNET-Router oder dergleichen, mit der Leitung verbunden ist, wobei an diesem Netzwerkgerät das erste Gerät angeschlossen ist. Alternativ oder ergänzend kann analog am mitnehmerseitigen Anschlussende ein aktives Netzwerkgerät mit der Leitung verbunden sein, wobei an diesem Netzwerkgerät das zweite Gerät angeschlossen ist. Durch die Verwendung handelsüblicher Netzwerkgeräte kann die zur Bereitstellung der Auswerteeinheit erforderliche Hardware auf ein Minimum reduziert werden. Andererseits kann zur Bereitstellung von Antworten auf Erreichbarkeitsanfragen ein eigens bzw. speziell vorgesehenes zweites Gerät mit minimalem Hardwareaufwand genutzt werden. Der Einsatz von verteilenden Netzwerkgeräten erlaubt zudem eine Ausnutzung einer für die gewünschte Anwendung ohnehin vorgesehenen Datenleitung für die Zwecke des Überwachungssystems.

Es liegt ebenfalls im Rahmen der Erfindung, dass die Überwachungsvorrichtung als zweites Gerät ein im Datennetz bzw. Datenbus ohnehin vorhandenes Netzwerkgerät bzw. Feldgerät mit vorbekannter Adresse ausnutzt. So kann insbesondere ein bereits vorhandenes Gerät genutzt werden, dass bestimmungsgemäß nicht für das Überwachungssystem vorgesehen ist.

Alternativ kann jedoch auch ein eigens für das Überwachungssystem vorgesehenes zweites Gerät an die Datenleitung angeschlossen werden. In beiden Fällen umfasst das erste Gerät vorzugsweise die Auswerteeinheit oder besteht aus letzterer.

Die zur Datenverbindung zwischen dem ersten Gerät und dem zweiten Gerät eingesetzte Datenleitung kann als eine Art Indikator für eine weitere durch die Leitungsführungseinrichtung geführte, zu überwachende Leitung dienen. In diesem Fall hat vorzugsweise diese oder jede weitere Leitung eine nominale Lebensdauer, die größer oder zumindest gleich der nominalen Lebensdauer der Datenleitung ist, welche die Schnittstellen beider Geräte verbindet und sozusagen als Sollbruchstelle bzw. schwaches Glied dient. Damit kann eine indirekte Überwachung einer anderen beispielsweise für die Anwendung besonders kritischen Leitung erfolgen. Alternativ kann die zu überwachende Leitung natürlich auch die Datenleitung zwischen den Schnittstellen umfassen oder aus dieser bestehen.

Die Schnittstelle beider Geräte ist zur Datenkommunikation vorzugsweise über eine elektrische Datenleitung verbunden, die durch die Leitungsführungseinrichtung bzw. Energieführungskette geführt ist. Diese Datenleitung kann eigens für das Überwachungssystem vorgesehen sein, die Erfindung ermöglicht jedoch besonders vorteilhaft auch die Nutzung einer für die Anwendung bereits vorhandenen Datenleitung als Bestandteil des Überwachungssystems.

Weiterhin ist es in einer bevorzugten Gestaltung möglich, anstelle einer konventionellen Datenleitung eine Stromversorgungsleitung zur Datenkommunikation zwischen dem ersten Gerät und dem zweiten Gerät einzusetzen. Hierzu können die Schnittstellen beispielsweise für POWERLAN, PLC bzw. einen anderweitigen IEEE-1901-Standard ausgeführt sein. So können die Schnittstellen beider Geräte signaltechnisch über eine in der Energieführungskette geführte Stromversorgungsleitung verbunden werden.

Ergänzend oder alternativ kann auch eine Hybrid-Servoleitung die beiden Datenkommunikationsgeräte bzw. deren Schnittstellen verbinden.

Eine Hybrid-Servoleitung umfasst eine Servoleitung zur Leistungsübertragung und eine integrierte Datenleitung, insbesondere eine Geberleitung. Die Vorteile der Hybrid-Servoleitung, welche oft auch als Einkabel-Leitung oder One-Cable-Technology-(OCT)-Leitung bezeichnet wird, sind neben geringerem Verdrahtungsaufwand auch Platzersparnis und Kostenreduktion. Die Datenübertragung erfolgt typisch digital aber, je nach Hersteller der versorgten Maschine, mittels verschiedenster Bustechnologien.

Das erste Gerät kann stationär am basisseitigen Ende der Leitungsführungseinrichtung bzw. am unbeweglichen Maschinenteil angeordnet sein. Das zweite Gerät ist dann am beweglichen Maschinenteil angeordnet, der durch die Leitungsführungseinrichtung mit Daten und/oder Energie versorgt wird.

Die erfindungsgemäße Ausnutzung eines informatischen bzw. datentechnischen Qualitätsmerkmals der Datenkommunikation zwischen beiden Geräten kann besonders vorteilhaft zur Leitungsüberwachung an einem Industrieroboter eingesetzt werden. Dabei ist die Leitungsführungseinrichtung vorzugsweise eine räumlich auslenkbare Energieführungskette, beispielsweise der Bauart wie in WO 2004/093279 A1 beschrieben. Als zweites Gerät kann dann ein am Endeffektor des Industrieroboters ohnehin vorgesehenes, adressierbares Netzwerk bzw. Feldgerät ausgenutzt werden. Nicht nur aber insbesondere bei Industrierobotern ist eine frühzeitige Erkennung eines anstehenden Leitungsversagens besonders vorteilhaft, da bei automatisierten Roboteranlagen Ausfallzeiten typischerweise besonders unerwünscht sind.

Es kommen neben Energieführungsketten aus einzelnen Gliedern auch alle andere Arten von dynamischen Leitungsführungen in Betracht, bei denen Leitungen im Betrieb dynamisch beansprucht werden. Rein beispielhaft offenbart z.B. WO 2016/042134 A1 eine flexible Leitungsführung für Reinraumanwendungen, auf welche die Erfindung ebenso anwendbar ist.

Das vorgeschlagene Überwachungssystem eignet sich aber insbesondere zur Zustandsüberwachung eines Daten- oder Stromversorgungskabels im laufenden Betrieb einer eigentlichen Energieführungskette und/oder zwecks vorausschauender bzw. präventiver Wartung zur Vermeidung von Ausfällen.

Weitere vorteilhafte Merkmale und Wirkungen der Erfindung werden nachfolgend ohne Beschränkung der Allgemeinheit des Vorstehenden anhand bevorzugter Ausführungsbeispiele mit Bezug auf die beigefügten Zeichnungen erläutert. Hierbei zeigen:
- **FIG.1:**: eine Prinzipskizze in Seitenansicht einer Energieführungskette mit einem erfindungsgemäßen Überwachungssystem nach einem ersten Ausführungsbeispiel;
- **FIG.2:**: eine Prinzipskizze in Seitenansicht einer Energieführungskette mit einem erfindungsgemäßen Überwachungssystem nach einem zweiten Ausführungsbeispiel;
- **FIG.3:**: eine Prinzipskizze in Seitenansicht mehrerer Energieführungsketten die mit einem erfindungsgemäßen Überwachungssystem nach einem dritten Ausführungsbeispiel überwacht werden; und
- **FIG.4:**: eine Seitenansicht eines Industrieroboters der räumlich auslenkbaren Energieführungskette, die mit einem Überwachungssystem gemäß FIG.1, FIG.2 oder FIG.3 ausgerüstet werden kann.

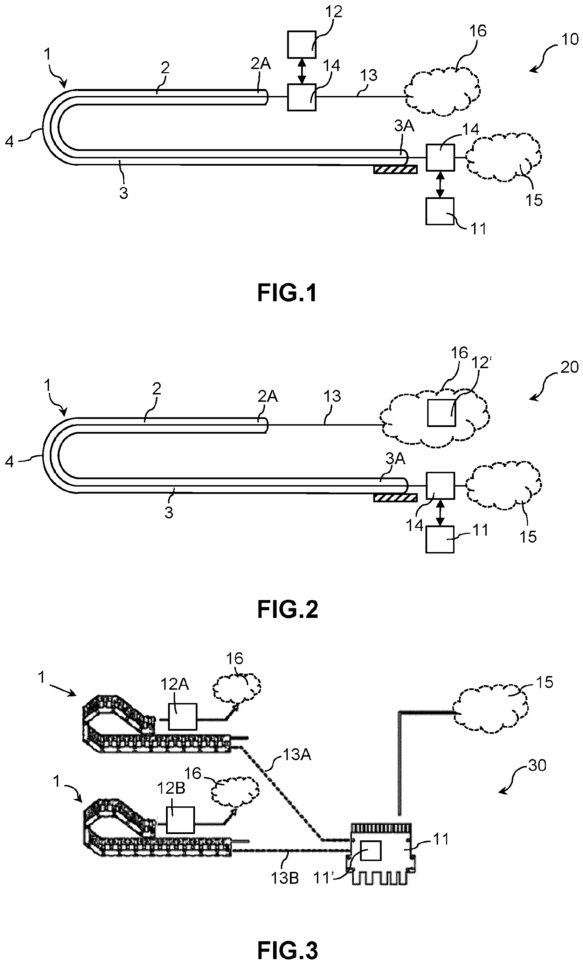

In FIG.1 ist als Beispiel einer dynamischen Leitungsführungseinrichtung eine schematisch gezeigte Energieführungskette allgemein mit 1 bezeichnet. Die Energieführungskette 1 dient zur geschützten Führung von Kabeln, Schläuchen oder ähnlichen Leitungen, die nicht näher gezeigt sind. Zwischen einem bewegten Trum 2, hier dem Obertrum, und einem ruhenden Trum 3, hier dem Untertrum, bildet die Energieführungskette 1 einen mitfahrenden Umlenkbogen 4 mit vorgegebener Krümmung. Der Umlenkbogen 4 hat zur Vermeidung von Leitungsbrüchen insbesondere einen vorgegebenen, minimalen Krümmungsradius und gewährleistet damit, dass die zulässigen Krümmungsradien der geführten Leitungen nicht unterschritten werden. Leitungsführungseinrichtung bildet typisch einen inneren Führungskanal, in welchem eine anwendungsabhängige Anzahl und Art von Leitungen geführt sind. Die Bauweise der Energieführungskette 1 ist nicht entscheidend für die Erfindung, es kommen z.B. alle an sich bekannten Energieführungsketten 1 aus einzelnen schwenkbar miteinander verbundenen Kettengliedern in Betracht.

FIG.1-3 zeigen rein beispielhaft linear und horizontal verfahrbare Energieführungsketten 1 zeigen. Das bewegte Trum 2 endet an einem ersten Anschlussende 2A, z.B. in einem Endglied, das an einem Mitnehmer eines beweglichen Maschinenteils (nicht gezeigt) befestigt ist. Das ruhende Trum 3 endet an einem zweiten Anschlussende 3A, z.B. in einem Endglied, das an einem festen Punkt der Maschine bzw. Anlage befestigt ist wie schematisch in FIG.1-2 angedeutet. Der Umlenkbogen 4 folgt mit halber Geschwindigkeit der Bewegung des fahrenden Anschlussendes 2A.

FIG.1 zeigt schematisch als einen wesentlichen Aspekt der Erfindung eine Überwachungsvorrichtung, die allgemein mit 10 bezeichnet ist. Die Überwachungsvorrichtung 10 umfasst ein erstes Gerät 11 mit einer Schnittstelle zur Datenkommunikation und ein zweites Gerät 12 mit einer Schnittstelle zur Datenkommunikation. Anhand ihrer Schnittstellen sind die Geräte 11, 12 zur Datenkommunikation, in FIG.1 bspw. gemäß ETHERNET-Protokoll bzw. einem zu IEEE 802.3 ähnlichen oder kompatiblen Protokoll, wie z.B. PROFINET, eingerichtet und können somit digitale Daten miteinander austauschen. Die Schnittstellen beider Geräte 11, 12 sind dazu über eine ETHERNET-Datenleitung 13, z.B. ein gängiges CAT5-Datenkabel mit einem verdrillten Datenleitungspaar (twisted pair), verbunden. Ein Längsabschnitt der Datenleitung 13 ist dabei, wie FIG.1 veranschaulicht, in der Leitungsführungseinrichtung bzw. Energieführungskette 1 geführt und geschützt.

Das erste Gerät 11 umfasst neben der ETHERNET-Schnittstelle zur Datenleitung 13 zumindest eine Auswerteeinheit die eingerichtet ist, um Information zum Zustand der zu überwachenden Leitung, hier z.B. der Datenleitung 13 selbst, basierend auf einem informatischen Qualitätsmerkmal der Datenverbindung zwischen den Geräten 11, 12 zu ermitteln.

Als erstes Gerät 11 kann beispielsweise eine handelsübliche modulare Rechnerplattform mit einem Mikroprozessor und diversen I/O-Schnittstellen einschließlich der ETHERNET-Schnittstelle verwendet werden. Zur informatischen Prüfung des Qualitätsmerkmals der Datenverbindung zwischen den Geräten 11, 12 kann dabei ein handelsübliches Betriebssystem für die Rechnerplattform genutzt werden das zur paketvermittelten Datenübertragung gemäß IP-Protokoll geeignet ist und protokollinhärent bzw. mit dem Betriebssystem eine Funktion für Erreichbarkeitsanfragen, wie etwa ein ICMP-Echo-Request bzw. eine PING-Nachricht gemäß TCP/IP-Protokoll oder vergleichbaren Protokollfamilien bereitstellt. In der Auswerteeinheit, hier im ersten Gerät 11, ist dazu die vorbekannte bzw. vorbestimmte Netz-Adresse des zweiten Geräts 12 gespeichert, sodass die Erreichbarkeitsanfrage an das zweite Gerät 12 adressiert werden kann. Die Auswerteeinheit prüft laufend, z.B. in regelmäßigen Zeitabständen, die Qualität der Datenverbindung anhand des Ausbleibens entsprechender Antworten, z.B. ECHO-Antworten bzw. PONG-Nachricht vom zweiten Gerät 12 an die Auswerteeinheit, hier im ersten Gerät, oder aber anhand von Veränderungen in den Eigenschaften dieser Antworten gegenüber einer Referenzantwort. Hierzu ist die Auswerteeinheit softwaremäßig mit einer geeigneten Funktionalität ausgestattet und hat weiterhin eine softwaremäßige Diagnosefunktion, welche das betrachtete Qualitätsmerkmal laufend überprüft.

Als Qualitätsmerkmal kann insbesondere die ermittelte Anzahl von Paketverlusten (Engl. "packet loss") eingesetzt werden, die typisch ein Ausgabewert eines ICMP-Echo-Request bzw. der PING-Funktion darstellt. Wenn die Anzahl von Paketverlusten über eine vorbestimmte Anzahl steigt, zeigt dies insbesondere eine durch Verschleiß oder Fehlverhalten bedingte Abnutzung oder Unterbrechung der Datenleitung 13 an. In diesem Fall gibt die Auswerteeinheit eine Warn- bzw. Fehlermeldung an einen übergeordnete Überwacher (vgl. FIG.3) ab, z.B. über die Datenleitung 13 oder vorzugsweise über einen separaten Kanal, sodass prädiktive Wartung ermöglicht wird.

Als zweites Gerät 12 kann grundsätzlich jedes preiswerte handelsübliche Netzwerkgerät bzw. Komponente eingesetzt werden, welches die gewählte Protokollfunktion, wie etwas Erreichbarkeitsanfragen, z.B. nach dem TCP/IP-Protokoll unterstützt, oder zumindest aber geeignet ist Empfangsbestätigungen an das erste Gerät zu senden, wenn etwa anstelle einer ETHERNET-Datenverbindung ein Feldbus-Protokoll wie CAN-Bus, EIA-485 oder dergleichen, eingesetzt wird. Im letztgenannten Fall kann die Auswerteeinheit, hier im ersten Gerät 11, z.B. einfach überwachen, ob auf jede Anfrage eine Empfangsbestätigung des zweiten Geräts 12 eingeht und gibt bei Erreichen einer vorbestimmten Fehlerschwelle ebenfalls eine Warn- bzw. Fehlermeldung aus.

Das zweite Gerät 12 kann ähnlich dem ersten Gerät 11 auch als speziell programmiertes Hardwaremodul bereitgestellt werden.

Die Ausnutzung an sich bekannter Kommunikationstechnologie bietet weitere Vorteile. Wie in FIG.1 veranschaulicht, sind die beiden Geräte 11, 12 der Überwachungsvorrichtung 10 jeweils an ein Vermittlungsgerät 14, wie ein ETHERNET-Switch, oder ein vergleichbares aktives Vermittlungs- bzw. Netzwerk-Gerät, angeschlossen. Dies erlaubt es, die Überwachungsvorrichtung 10 mit ihren Geräten 11, 12, nahtlos in eine bestehende bzw. gewünschte anwendungsabhängige Netz- bzw. Bus-Struktur zu integrieren, und zur Überwachung eine ohnehin vorgesehene Datenleitung 13 für anwendungsbezogene Nutzdaten zu nutzen. Die Datenleitung 13 kann z.B. für Nutzdaten, wie z.B. Steuerungs- und/oder Messdaten, die zwischen einem ersten Bereich 15 des Datennetzes bzw. des Datenbus und einem zweiten Bereich 16 des Datennetzes bzw. des Datenbus dienen. Hier sind die Bereiche 15, 16 anhand der Vermittlungsgeräte 14 über die Datenleitung 13 verbunden.

Die Geräte 11, 12 der Überwachungsvorrichtung 10 bewirken dank der Vermittlungsgeräte 14 keine nennenswerte Beeinträchtigung der Kommunikation zwischen den Bereichen 15, 16. Die Vermittlungsgeräte 14 sind beide möglichst nahe an den Anschlussenden 2A, 3A der Energieführungskette 1 angeordnet, um den geprüften Leitungsabschnitt möglichst auf den Bereich in der Leitungsführungseinrichtung zu begrenzen.

Der erste Bereich 15 der Kommunikationstopologie kann dabei am einem ortsfesten Teil der Maschine bzw. Anlage angeordnet sein und z.B. die Steuerung umfassen. Der zweite Bereich 16 umfasst z.B. Sensoren und/oder Aktoren am relativbeweglichen Teil der Maschine bzw. Anlage.

In der Architektur der Überwachungsvorrichtung 10 nach FIG.1 ist neben der speziell konfigurierten und mit der erforderlichen Software programmierten Auswerteeinheit im ersten Gerät 11 ein eigens für die Zwecke der Überwachungsvorrichtung 10 konfiguriertes zweites Gerät 12 vorgesehen. Dies ist jedoch dank der Ausnutzung bestehender Technologie nicht erforderlich.

Sofern eine eindeutige Netz-Adresse bzw. Bus-Adresse eines im zweiten Bereich 16 des Datennetzes bzw. Datenbus vorgesehenen weiteren Geräts 12' vorbekannt ist, kann dieses weitere Gerät 12' für die vorstehenden Zwecke genutzt werden. Gängige Netzwerkgeräte bzw. Feldgeräte bringen die erforderliche Technik, jedenfalls bei geeigneter Auswahl des betrachteten Qualitätsmerkmals, typischerweise bereits mit sich. Ein entsprechendes zweites Ausführungsbeispiel ist in FIG.2 schematisch dargestellt. Die Überwachungsvorrichtung 20 nach FIG.2 unterscheidet sich dadurch, dass die Auswerteeinheit, z.B. im ersten Gerät 11 implementiert, unmittelbar mit einem anwendungsspezifischen Gerät 12` im zweiten Bereich 16 kommuniziert. Das weitere Gerät 12` kann dabei z.B. inhärent für die Beantwortung eines ECHO-Request, oder zur Empfangsbestätigung von adressierten Bus-Daten, konfiguriert sein. Somit ist ein besonderes zweites Gerät und ein Vermittlungsgerät gemäß FIG.1 nicht zwingend erforderlich. Im Übrigen entsprechen Aufbau und Funktion der Überwachungsvorrichtung 20 nach FIG.2 derjenigen aus FIG.1.

Eine weitere Variante einer Überwachungsvorrichtung 30 ist in FIG.3 gezeigt. Hierbei ist als erstes Gerät 11 z.B. eine anwendungsspezifische Steuerungs- oder Überwachungseinheit vorgesehen, in welche eine Auswerteeinheit 11` als Zusatzmodul, in Form von geeigneter Hardware oder Software, integriert ist. Die Auswerteeinheit 11` ist dabei eingerichtet um parallel das ausgewählte informatische Qualitätsmerkmal von mehreren Datenverbindungen zwischen dem gemeinsamen ersten Gerät 11 und jeweils einem von mehreren zweiten Geräten 12A, 12B... zu ermitteln. Das erstes Gerät 11 mit der Auswerteeinheit 11` kann so parallel mehrere Leitungen 13A, 13B... in unterschiedlichen Energieführungsketten 1 überwachen. FIG.3 veranschaulicht rein beispielhaft zwei überwachte Energieführungsketten 1. Das erste Gerät 11 kann hier für weitere Funktionen mit dem ersten Netz- bzw. Bus-Bereich 15 und über die Leitungen 13A, 13B... auch mit jeweils mehreren zweiten Netz- bzw. Bus-Bereichen 16 einer komplexeren Anlage bzw. Maschine verbunden sein.

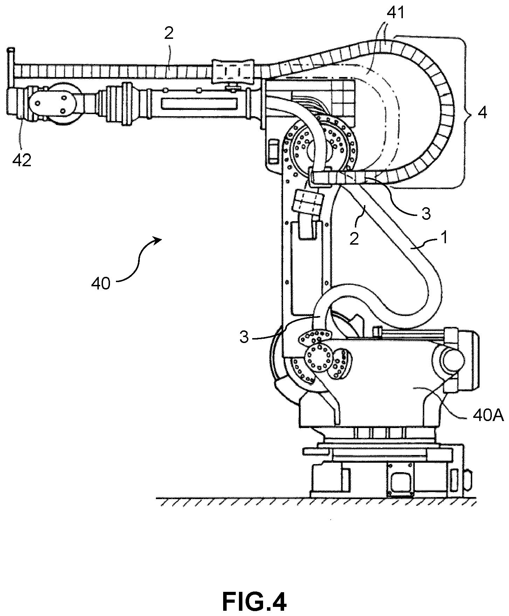

FIG.4 zeigt als beispielhaften Anwendungsfall für eine Überwachungsvorrichtung 10, 20, 30 einen Gelenkarmroboter 40, z.B. zur vollautomatischen Handhabung von Werkstücken in einem Fertigungsprozess. Von der ortsfesten Basis 40A des Gelenkarmroboters führt hier z.B. eine erste linear verfahrbare Energieführungskette 1, ähnlich FIG.1-3, zu einem Drehgelenk von dem aus eine räumlich auslenkbare zweite Energieführungskette 41 (z.B. gemäß WO 2004/093279 A1) weiterführt zum Endeffektor 42 bzw. endseitigen Roboterwerkzeug. Am Endeffektor 42 sind typisch eine Anzahl Aktoren und Sensoren vorgesehen die bereits für ein gängiges Feldbus-Protokoll oder z.B. das PROFINET-Protokoll geeignet sind.

Die Adresse dieser Feldgeräte bzw. Netzwerkgeräte ist vorbestimmbar bzw. programmierbar. Unter Anwendung einer Überwachungsvorrichtung 10, 20, 30 nach dem Prinzip aus FIG.1-3 kann mindestens eine oder aber alle Datenleitungen die durch die Energieführungsketten 1, 41 geführt sind auf ihren Verschleiß-Zustand hin überwacht werden. Hierzu ist lediglich ein preiswert realisierbares erstes Gerät 11, z.B. mit einer Auswerteeinheit 11' in Form eines Softwaremoduls auf einem Rechner, erforderlich. Es kann dazu eine bereits vorhandene Steuerungs-Einheit oder Überwachungseinheit genutzt werden (vgl. FIG.3).

Das vorgeschlagene Überwachungssystem zur Überwachung des Leitungszustands bietet somit eine preiswerte Lösung zur Unterstützung prädiktiver Wartung und/oder zur Verringerung bzw. Vermeidung von Ausfallzeiten. Die Erfindung erlaubt es u.a. anfälligere und ggf. auch kostenintensive Datenleitungen, Spezialleitungen oder dgl. hinsichtlich ihrer möglichen Lebensdauer maximal zu nutzen d.h. einen unnötig frühen Austausch zu vermeiden.

### System zur Leitungsüberwachung in einer Leitungsführungseinrichtung, insbesondere in einer Energieführungskette

### Bezugszeichenliste

**FIG.1-3**
   - 1: Leitungsführungseinrichtung (Energieführungskette)
   - 2: bewegtes Trum
   - 2A: erstes Anschlussende
   - 3: ruhendes Trum
   - 3A: zweites Anschlussende
   - 4: Umlenkbogen
   - 10, 20, 30: Überwachungsvorrichtung
   - 11: erstes Gerät
   - 12; 12'; 12A, 12B: zweites Gerät
   - 13; 13A, 13B: Datenleitung
   - 14: Vermittlungsgerät (ETHERNET-Switch)
   - 15: erster Bereich (Kunden-Netz/-Bus)
   - 16: zweiter Bereich (Kunden-Netz/-Bus)
**FIG. 4**
   - 1: erste Energieführungskette (linear verfahrbar)
   - 2: erstes Trum
   - 3: zweites Trum
   - 4: Umlenkbogen
   - 40: Gelenkarmroboter
   - 40A: Basis
   - 41: zweite Energieführungskette (räumlich auslenkbar)
   - 42: Endeffektor

## Patentansprüche

1. Überwachungssystem zur Überwachung des Zustands mindestens einer Leitung die durch eine Leitungsführungseinrichtung, insbesondere eine Energieführungskette, geführt ist, wobei die mindestens eine Leitung (13; 13A; 13B) geführt wird durch eine verfahrbare Leitungsführungseinrichtung (1; 41) zum Führen der Leitung zwischen einer ersten Anschlussstelle und einer dazu relativbeweglichen zweiten Anschlussstelle, das Überwachungssystem umfassend:
- eine Überwachungsvorrichtung (10; 20; 30), die eine Auswerteeinheit aufweist, welche Information zum Zustand der zu überwachenden Leitung ermittelt;
**dadurch gekennzeichnet, dass**
- die Überwachungsvorrichtung (10; 20; 30) zumindest ein erstes Gerät (11) umfasst, welches eine Schnittstelle zur Datenkommunikation gemäß einem Protokoll zur digitalen Datenübertragung aufweist, und eingerichtet ist zur Kommunikation mit einem zweiten Gerät (12'), welches eine Schnittstelle zur Datenkommunikation gemäß demselben Protokoll zur digitalen Datenübertragung aufweist;
- wobei die Schnittstellen beider Geräte über die mindestens eine Leitung (13; 13A; 13B) verbindbar sind; und
- dass das erste Gerät (11) die Auswerteinheit umfasst und die Auswerteeinheit eingerichtet ist, um Information zum Zustand der zu überwachenden Leitung basierend auf einem informatischen Qualitätsmerkmal einer Datenverbindung zwischen dem ersten Gerät (11) und dem zweiten Gerät (12') zu ermitteln.

2. Überwachungssystem nach Anspruch 1, **dadurch gekennzeichnet, dass** die Überwachungsvorrichtung (20) als zweites Gerät (12') ein adressierbares Netzwerkgerät bzw. Feldgerät nutzt, insbesondere ein anwendungsspezifisch in einem Datennetz bzw. Datenbus der zu überwachenden Anlange bzw. Maschine bereits vorhandenes handelsübliches Netzwerkgerät bzw. Feldgerät, wobei das zweite Gerät (12') insbesondere bestimmungsgemäß nicht für das Überwachungssystem und/oder nicht eigens für das Überwachungssystem vorgesehen ist.

3. Überwachungssystem nach Anspruch 1 oder 2, **dadurch gekennzeichnet, dass** das Protokoll ein Protokoll zur paketbasierten digitalen Datenübertragung ist, vorzugsweise ein Datennetz-Protokoll gemäß IEEE 802.3, wie ETHERNET bzw. PROFIBUS oder dergleichen, und/oder die Geräte (11; 12') zur Datenkommunikation mit Paketvermittlung eingerichtet sind.

4. Überwachungssystem nach Anspruch 1 oder 2, **dadurch gekennzeichnet, dass** das Protokoll ein Datenbus-Protokoll, wie CAN-Bus, EIA-485 oder dergleichen, insbesondere ein industrielles Feldbus-Protokoll ist.

5. Überwachungssystem nach einem der Ansprüche 1 bis 4, **dadurch gekennzeichnet, dass** beide Schnittstellen zur Datenkommunikation eine eindeutige Adresse aufweisen, wobei das Qualitätsmerkmal informatisch durch an das zweite Gerät (12') adressierte Datenübertragung bestimmbar ist.

6. Überwachungssystem nach einem der Ansprüche 1 bis 5, **dadurch gekennzeichnet, dass** die Auswerteeinheit (11) eingerichtet ist, um das Qualitätsmerkmal laufend, insbesondere in regelmäßigen Abständen, zu bestimmen.

7. Überwachungssystem nach einem der Ansprüche 1 bis 6, insbesondere nach Anspruch 4, **dadurch gekennzeichnet, dass** die Auswerteeinheit (11) eingerichtet ist, um das Qualitätsmerkmal informatisch bzw. softwaremäßig zu bestimmen, vorzugsweise anhand von protokollinhärenten Funktionen, insbesondere anhand von
- Erreichbarkeitsanfragen vom ersten Gerät an das zweite Gerät;
- Empfangsbestätigungen vom zweiten Gerät an das erste Gerät; und/oder
- Paketverlusten bzw. Paketverlustraten bei paketbasierter Datenübertragung; und/oder
- mindestens einer protokollinhärenten Funktion zur Beurteilung eines Dienstgüte(QoS)-Parameters.

8. Überwachungssystem nach Anspruch 6, **dadurch gekennzeichnet, dass** das erste Gerät Erreichbarkeitsanfragen (PING) gemäß einem übergeordneten Protokoll an das zweite Gerät sendet, und die Auswerteeinheit die Qualität der Datenverbindung anhand des Ausbleibens entsprechender Antworten (PONG) bzw. deren Veränderung gegenüber einer Referenzantwort beurteilt.

9. Überwachungssystem nach einem der vorstehenden Ansprüche, **dadurch gekennzeichnet, dass** die Auswerteinheit vorzugsweise eine programmierbare integrierte Schaltung, wie einen Mikrocontroller oder dergleichen, aufweist.

10. Überwachungssystem nach einem der Ansprüche 1 bis 9, weiterhin umfassend die verfahrbare Leitungsführungseinrichtung (1; 41) und die darin geführte Leitung (13; 13A; 13B).

11. Überwachungssystem nach Anspruch 10, **dadurch gekennzeichnet**
- **dass** die Leitungsführungseinrichtung eine Energieführungskette (1; 41) ist, insbesondere eine Energieführungskette die ein bewegliches Trum (2) mit einem ersten Anschlussende (2A), ein ruhendes Trum (3) mit einem zweiten Anschlussende (3A) sowie zwischen beiden Trumen einen Umlenkbogen (3) bildet; und/oder
- **dass** mindestens eine weitere Leitung durch die Leitungsführungseinrichtung geführt ist, wobei jede weitere Leitung eine nominale Lebensdauer aufweist, die größer oder gleich der nominalen Lebensdauer der Leitung (13, 13A, 13B) ist, über welche die Schnittstellen beider Geräte verbunden sind.

12. Überwachungssystem nach einem der Ansprüche 1 bis 11, **dadurch gekennzeichnet, dass** die beiden Schnittstellen für POWERLAN, PLC bzw. IEEE-1901-Standard oder dergleichen ausgeführt sind und die Schnittstellen beider Geräte zur Datenkommunikation über eine durch die Leitungsführungseinrichtung geführte Stromversorgungsleitung signaltechnisch verbunden sind.

13. Überwachungssystem nach einem der Ansprüche 1 bis 11, **dadurch gekennzeichnet, dass**
- die Schnittstellen beider Geräte (11, 12) zur Datenkommunikation über eine durch die Leitungsführungseinrichtung geführte elektrische Datenleitung (13) verbunden sind, wobei vorzugweise die zu überwachende Leitung die Datenleitung umfasst oder eine Datenleitung ist, insbesondere ein ETHERNET-fähiges mehradriges Kupfer-Datenkabel; oder
- die Schnittstellen beider Geräte (11, 12) zur Datenkommunikation über eine Hybrid-Servoleitung verbunden sind.

14. Industrieroboter (40) umfassend eine verfahrbare Leitungsführungseinrichtung (1; 41) und eine darin geführte Leitung (13; 13A; 13B) **gekennzeichnet durch** ein Überwachungssystem nach einem der Ansprüche 1 bis 13, weiterhin umfassend das zweite Gerät (12') **wobei** die Leitungsführungseinrichtung (41) räumlich auslenkbar ist, und als zweites Gerät (12') ein insbesondere an einem Endeffektor (42) des Industrieroboters vorgesehenes, adressierbares Netzwerkgerät bzw. Feldgerät genutzt wird.

15. Verwendung eines Überwachungssystems nach einem der Ansprüche 1 bis 15 zur Zustandsüberwachung eines Daten- oder Stromversorgungskabels in einer Energieführungskette bei laufendem Betrieb, insbesondere zwecks präventiver Wartung.

## Claims

1. A monitoring system for monitoring the condition of at least one line guided by a line guide apparatus, in particular an energy guide chain, wherein the at least one line (13; 13A; 13B) is guided by a displaceable line guide apparatus (1; 41) for guiding the line between a first connection point and a second connection point, the monitoring system comprising:
- a monitoring device (10; 20; 30) having an evaluation unit which detects information about the condition of the line to be monitored;
**characterized in that**
- the monitoring device (10; 20; 30) comprises at least a first device (11), which has an interface for data communication according to a protocol for digital data transmission and which is configured to communicate with a second device (12'), which has an interface for data communication according to the same protocol for digital data transmission;
- wherein the interfaces of the two devices are connectable by way of the at least one line (13; 13A; 13B); and
- that the first device (11) comprises the evaluation unit and the evaluation unit is configured to detect information about the condition of the line to be monitored on the basis of an information technological quality feature of a data link between the first device (11) and the second device (12').

2. The monitoring system according to Claim 1, **characterized in that** the monitoring device (20) uses as second device (12') an addressable network device or field device, in particular a commercially available network device or field device already being application-specific present in a data network or data bus of the system or device to be monitored, which second device (12') is in particular not provided specifically for the monitoring system or not provided expressly for the monitoring system.

3. The monitoring system according to Claim 1 or 2, **characterized in that** the protocol is a protocol for packet-based digital data transmission, preferably a data network protocol according to IEEE 802.3, such as ETHERNET or PROFIBUS or the like, and/or the devices (11; 12') are configured for data communication with packet switching.

4. The monitoring system according to Claim 1 or 2, **characterized in that** the protocol is a data bus protocol, such as CAN bus, EIA-485 or the like, in particular an industrial field bus protocol.

5. The monitoring system according to any one of Claims 1 to 4, **characterized in that** both interfaces have a unique address for data communication, wherein the quality feature is determinable using information technology (IT) by data transmission addressed to the second device (12').

6. The monitoring system according to one of Claims 1 to 5, **characterized in that** the evaluation unit (11) is configured to determine the quality feature continuously, in particular at regular intervals.

7. The monitoring system according to one of Claims 1 to 6, in particular according to Claim 4, **characterized in that** the evaluation unit (11) is configured to determine the quality feature using information technology (IT) or using software, preferably on the basis of protocol-inherent functions, in particular on the basis of availability requests from the first device to the second device; receipt acknowledgments from the second device to the first device; and/or packet losses or packet loss rates in packet-based data transmission; and/or at least one protocol-inherent function for assessing a quality of service (QoS) parameter.

8. The monitoring system according to Claim 7, **characterized in that** the first device sends availability requests (PING) according to a higher-level protocol to the second device, and the evaluation unit assesses the quality of the data link on the basis of the absence of corresponding responses (PONG) or changes thereto relative to a reference response.

9. The monitoring system according to one of the preceding claims, **characterized in that** the evaluation unit preferably has a programmable integrated circuit, such as a microcontroller or the like.

10. The monitoring system according to one of claims 1 to 9, further comprising the displaceable line guide apparatus (1; 41) and the line (13; 13A; 13B) guided therein.

11. The monitoring system according to Claim 10, **characterized**
- **in that** the line guide apparatus is an energy guide chain (1; 41), in particular an energy guide chain which forms a mobile run (2) with a first connection end (2A), a stationary run (3) with a second connection end (3A) and a deflection arc (3) between the two runs, and/or
- **in that** at least one further line is guided by the line guide apparatus, wherein each further line has a nominal service life which is greater than or equal to the nominal service life of the line (13, 13A, 13B), via which the interfaces of the two devices are connected.

12. The monitoring system according to one of Claims 1 to 11, **characterized in that** the both interfaces are embodied for POWERLAN, PLC or the IEEE 1901 standard or the like and the interfaces of the two devices are connected for signaling via a power supply line guided by the line guide apparatus.

13. The monitoring system according to one of Claims 1 to 11, **characterized in that**
- the interfaces of the two devices (11, 12) for data communication are connected via an electrical data line (13) guided by the line guide apparatus, wherein the line to be monitored preferably comprises the data line or is a data line, in particular an ETHERNET-capable, multicore copper data cable; or
- the interfaces of the two devices (11, 12) are connected for data communication via a hybrid servo line.

14. An industrial robot (40) comprising a displaceable line guide apparatus (1; 41) and a line (13; 13A; 13B) guided therein **characterized by** a monitoring system according to one of Claims 1 to 13 further comprising the second device (12'), **wherein** the line guide apparatus (41) is three-dimensionally deflectable, and as second device (12') an addressable network device or field device is used which is in particular provided on an end effector (42) of the industrial robot.

15. Use of a monitoring system according to one of Claims 1 to 3, for monitoring the condition of a data or power supply cable in an energy guide chain in ongoing operation, in particular for the purpose of preventive maintenance.

## Revendications

1. Système de surveillance pour surveiller l'état d'au moins une ligne qui est guidée par un dispositif de guidage de ligne, en particulier une chaîne de guidage d'énergie, ladite au moins une ligne (13; 13A; 13B) étant guidée par un dispositif de guidage de ligne déplaçable (1; 41) pour guider la ligne entre un premier point de raccordement et un deuxième point de raccordement mobile de manière relative par rapport à ce dernier, le système de surveillance comprenant:
- un dispositif de surveillance (10; 20; 30) qui présente une unité d'évaluation qui détermine des informations sur l'état de la ligne à surveiller;
**caractérisé en ce que**
- le dispositif de surveillance comprend au moins un premier appareil (11) avec une interface pour la communication de données selon un protocole pour la transmission numérique de données et est agencé pour la communication avec un deuxième appareil (12; 12') ayant une interface pour la communication de données selon le même protocole pour la transmission de données;
- les interfaces des deux appareils peuvent être reliées par l'intermédiaire de ladite au moins une ligne (13; 13A; 13B) et
- que le premier appareil (11) comporte l'unité d'évaluation, et l'unité d'évaluation est agencée pour déterminer des informations sur l'état de la ligne à surveiller sur la base d'une caractéristique de qualité informatique de la liaison de données entre le premier appareil (11) et le deuxième appareil (12').

2. Système de surveillance selon la revendication 1, **caractérisé en ce que** le dispositif de surveillance (20) utilise comme deuxième appareil (12') un appareil de réseau ou un appareil de terrain adressable, en particulier un appareil de réseau ou un appareil de terrain usuel déjà présent de manière spécifique à l'application dans un réseau de données ou un bus de données de l'installation ou de la machine à surveiller, le deuxième appareil (12'), en particulier conformément à sa destination, n'étant pas prévu pour le système de surveillance et/ou n'étant pas prévu spécialement pour le système de surveillance.

3. Système de surveillance selon la revendication 1 ou 2, **caractérisé en ce que** le protocole est un protocole de transmission de données numériques par paquets, de préférence un protocole de réseau de données selon IEEE 802.3, tel que ETHERNET ou PROFIBUS ou similaire, et/ou les appareils (11; 12') sont agencés pour la communication de données avec commutation de paquets.

4. Système de surveillance selon la revendication 1 ou 2, **caractérisé en ce que** le protocole est un protocole de bus de données, tel que CAN-Bus, EIA-485 ou similaire, en particulier un protocole de bus de terrain industriel.

5. Système de surveillance selon l'une des revendications 1 à 4, **caractérisé en ce que**, pour la communication de données, les deux interfaces présentent une adresse univoque, la caractéristique de qualité pouvant être déterminée de manière informatique par une transmission de données adressée au deuxième appareil (12').

6. Système de surveillance selon l'une des revendications 1 à 5, **caractérisé en ce que** l'unité d'évaluation (11) est agencée pour déterminer en permanence, notamment à intervalles réguliers, la caractéristique de qualité.

7. Système de surveillance selon l'une des revendications 1 à 6, **caractérisé en ce que** l'unité d'évaluation (11) est agencée pour déterminer la caractéristique de qualité de manière informatique ou au niveau logiciel, de préférence à l'aide de fonctions inhérentes au protocole, en particulier à l'aide
- de demandes d'accessibilité du premier appareil au deuxième appareil;
- d'accusés de réception envoyés par le deuxième appareil au premier appareil et/ou
- de pertes de paquets ou de taux de perte de paquets lors de la transmission de données par paquets; et/ou
- d'au moins une fonction inhérente au protocole pour évaluer un paramètre de qualité de service (QoS).

8. Système de surveillance selon la revendication 6, **caractérisé en ce que** le premier appareil envoie des demandes d'accessibilité (PING) au deuxième appareil selon un protocole de niveau supérieur, et l'unité d'évaluation évalue la qualité de la connexion de données à l'aide de l'absence de réponses correspondantes (PONG) ou de leur variation par rapport à une réponse de référence.

9. Système de surveillance selon l'une des revendications précédentes, **caractérisé en ce que** l'unité d'évaluation comprend de préférence un circuit intégré programmable, tel qu'un microcontrôleur ou similaire.

10. Système de surveillance selon l'une des revendications 1 à 9, comprenant en outre le dispositif de guidage de ligne déplaçable (1; 41) et la ligne (13; 13A, 13B) qui y est guidée.

11. Système de surveillance selon la revendication 10, **caractérisé en ce**
- **que** le dispositif de guidage de ligne est une chaîne de guidage d'énergie (1; 41), notamment une chaîne porte-câbles, qui forme un brin mobile (2) avec une première extrémité de raccordement (2A), un brin au repos (3) avec une deuxième extrémité de raccordement (3A) ainsi qu'un arc de déviation (3) entre les deux brins; et/ou
- **qu'**au moins une autre ligne est guidée par le dispositif de guidage de ligne, chaque autre ligne présentant une durée de vie nominale supérieure ou égale à la durée de vie nominale de la ligne (13, 13A, 13B) par laquelle les interfaces des deux appareils sont reliées.

12. Système de surveillance selon l'une des revendications 1 à 11, **caractérisé en ce que** les deux interfaces sont agencées pour POWERLAN, PLC ou la norme IEEE-1901 ou similaire et **en ce que**, pour la communication de données, les interfaces des deux appareils sont reliées en terme de signalisation via une ligne d'alimentation électrique guidée par le dispositif de guidage de ligne.

13. Système de surveillance selon l'une des revendications 1 à 11, **caractérisé en ce que**
- pour la communication de données, les interfaces des deux appareils (11, 12) sont reliées par une ligne de données électrique (13) guidée par le dispositif de guidage de ligne, la ligne à surveiller comprenant de préférence la ligne de données ou étant un câble de données, notamment un câble en cuivre multiconducteur compatible avec ETHERNET; ou
- pour la communication de données, les interfaces des deux appareils (11, 12) sont reliées par une ligne d'asservissement hybride.

14. Robot industriel (40), comprenant un dispositif de guidage de ligne (1; 41) déplaçable et une ligne (13; 13A, 13B) qui y est guidée, **caractérisé par** un système de surveillance selon l'une des revendications 1 à 13, comprenant en outre le deuxième appareil (12'), le dispositif de guidage de ligne (41) pouvant être dévié dans l'espace, et un dispositif de réseau ou un dispositif de terrain adressable notamment prévu sur un effecteur d'extrémité (42) du robot industriel étant utilisé comme deuxième appareil (12').

15. Utilisation d'un système de surveillance selon l'une des revendications 1 à 15 pour la surveillance de l'état d'un câble de données ou d'alimentation dans une chaîne de guidage d'énergie en cours de fonctionnement, notamment à des fins de maintenance préventive.
